# DEMANDE DE BREVET EUROPEEN

(11) **EP 3 244 536 A1**
(43) Date de publication de la demande: **15.11.2017**
(21) Numéro de dépôt: 17170560.1
(22) Date de dépôt: 11.05.2017
(51) Int. Cl.: H03K 17/082, H03K 17/16, H03K 5/08

(54) **CIRCUIT DE LIMITATION DE TENSION, SYSTÈME D'INTERRUPTEUR ET CONVERTISSEUR ÉLECTRIQUE**

(30) Priorité: 11.05.2016 FR 1654184
(71) Demandeur: Valeo Systemes de Controle Moteur, 95800 Cergy Saint Christophe (FR)
(72) Inventeur: BERTRAND, Mathieu, 94046 CRETEIL (FR); NIKOLIC, David, 95800 CERGY SAINT CHRISTOPHE (FR); PLAIDEAU, Michel, 95800 CERGY SAINT CHRISTOPHE (FR)
(74) Mandataire: Cardon, Nicolas

(57) **Abrégé**

Le circuit de limitation de tension (128₁) comporte : une première borne (136₁) et une deuxième borne (138₁), une tension d'entrée (V₁) étant destinée à être présentée sur la deuxième borne (138₁) par rapport à la première borne (136₁) ; un premier circuit (140₁) connecté entre la première borne (136₁) et la deuxième borne (138₁) et conçu pour, lorsque la tension d'entrée (V₁) est inférieure à un premier seuil, présenter une résistance élevée entre la première borne (136₁) et la deuxième borne (138₁), et, lorsque la tension d'entrée (V₁) est supérieure au premier seuil, présenter une résistance faible, au moins 100 fois plus faible que la résistance élevée, entre la première borne (136₁) et la deuxième borne (138₁).

Le circuit de limitation de tension (128₁) comporte en outre un deuxième circuit (148₁) connecté à la première borne (138₁) et conçu pour, lorsque la tension d'entrée (V₁) augmente depuis un troisième seuil jusqu'au deuxième seuil, recevoir du courant en provenance de la deuxième borne (138₁).

## Description

### DOMAINE TECHNIQUE

La présente invention concerne le domaine des interrupteurs commandés, en particulier dans des applications où ces interrupteurs sont destinés à être parcourus par des courants supérieurs à 100 A.

### ARRIÈRE-PLAN TECHNOLOGIQUE

La demande de brevet européen publiée sous le numéro EP 2 549 649 A1 décrit un circuit de limitation de tension comportant :
- une première borne et une deuxième borne, une tension d'entrée étant destinée à être présentée sur la deuxième borne par rapport à la première borne,
- un premier circuit connecté entre la première borne et la deuxième borne et conçu pour :
   - lorsque la tension d'entrée est inférieure à un premier seuil, présenter une résistance élevée entre la première borne et la deuxième borne,
   - lorsque la tension d'entrée est supérieure au premier seuil, présenter une résistance faible, au moins 100 fois plus faible que la résistance élevée, entre la première borne et la deuxième borne.

Le circuit de limitation de tension de la publication précédente est destiné à limiter la tension d'entrée à la valeur du premier seuil. Or, les inventeurs ont remarqué que, lorsqu'une tension croissante est appliquée en tant que tension d'entrée sur le circuit de limitation de tension, cette tension croissante n'est pas limitée convenablement mais oscille pendant un moment autour du premier seuil, les premières oscillations pouvant présenter une amplitude importante.

L'invention a pour but de proposer un circuit de limitation de tension permettant de résoudre au moins en partie les problèmes indiqués ci-dessus.

### RÉSUMÉ DE L'INVENTION

À cet effet, il est proposé un circuit de limitation de tension comportant :
- une première borne et une deuxième borne, une tension d'entrée étant destinée à être présentée sur la deuxième borne par rapport à la première borne,
- un premier circuit connecté entre la première borne et la deuxième borne et conçu pour :
   - lorsque la tension d'entrée est inférieure à un premier seuil, présenter une résistance élevée entre la première borne et la deuxième borne,
   - lorsque la tension d'entrée est supérieure au premier seuil, présenter une résistance faible, au moins 100 fois plus faible que la résistance élevée, entre la première borne et la deuxième borne,
caractérisé en ce qu'il comporte en outre :
- un deuxième circuit connecté à la deuxième borne et conçu pour, lorsque la tension d'entrée augmente depuis un deuxième seuil jusqu'au premier seuil, recevoir du courant en provenance de la deuxième borne.

En effet, les inventeurs ont constaté que le branchement du circuit de limitation de tension à un autre circuit pouvait entraîner l'apparition d'une inductance parasite connectée à la deuxième borne. Or, lorsque la tension d'entrée atteint le premier seuil, un fort courant est brusquement appelé par la deuxième borne. Ce courant traversant également l'inductance parasite, l'inductance parasite réagit en présentant une forte tension entre ses bornes. Grâce à l'invention, lorsque la tension d'entrée augmente avant d'atteindre le premier seuil, le deuxième circuit reçoit du courant par la deuxième borne. Ainsi, lorsque la tension d'entrée atteint le premier seuil, un courant entrant est déjà présent, de sorte que le courant entrant par la deuxième borne varie moins brusquement, ce qui limite l'effet indésirable de l'inductance parasite.

De façon optionnelle, le deuxième circuit comporte une capacité présentant une première borne connectée à la deuxième borne du circuit de limitation de tension.

De façon optionnelle également, le premier circuit comporte une diode présentant une cathode connectée à la première borne du circuit de limitation de tension.

De façon optionnelle également, la capacité présente une deuxième borne connectée à une anode de la diode.

De façon optionnelle également, le premier circuit comporte en outre une diode Zener présentant une cathode connectée à la deuxième borne du circuit de limitation de tension.

De façon optionnelle également, la diode Zener comporte une anode connectée à une anode de la diode.

De façon optionnelle également, le deuxième circuit comporte en outre un troisième circuit conçu pour recevoir une commande de décharge et, en réponse à la réception de la commande de décharge, décharger la capacité.

De façon optionnelle également, le troisième circuit comporte une résistance et un interrupteur conçu pour, en réponse à la commande de décharge, connecter la capacité à la résistance pour permettre une décharge de la capacité dans la résistance.

Avantageusement, lorsque cet interrupteur est ouvert, aucun courant ne circule au travers de la résistance, ce qui limite le courant de fuite traversant le circuit de limitation de tension lorsque ce circuit est connecté entre la grille et le drain d'un interrupteur de côte haut ou de côté bas à l'état ouvert d'un convertisseur électrique.

De façon optionnelle également, le premier circuit est conçu pour, lorsque la tension d'entrée est inférieure au premier seuil, présenter une résistance d'au moins 100 kΩ, de préférence d'au moins 1 MΩ entre les bornes du circuit de limitation de tension.

De façon optionnelle également, le premier circuit est conçu pour, lorsque la tension d'entrée est supérieure au premier seuil, présenter une résistance d'au plus 100 Ω, de préférence d'au plus 10 Ω entre les bornes du circuit de limitation de tension.

De façon optionnelle également, le deuxième circuit est conçu pour, lorsque la tension d'entrée augmente à une vitesse comprise entre 50V par µs et 200V par µs depuis le deuxième seuil jusqu'au premier seuil, recevoir un courant d'au moins 10mA, de préférence d'au moins 100 mA, de préférence encore d'au moins 200 mA, en provenance de la deuxième borne du circuit de limitation de tension.

De façon optionnelle également, le deuxième circuit est conçu pour, lorsque la tension d'entrée augmente à une vitesse comprise entre 50V par µs et 2000V par µs depuis le deuxième seuil jusqu'au premier seuil, recevoir un courant d'au moins 10mA, de préférence d'au moins 100 mA, de préférence encore d'au moins 200 mA, de préférence encore d'au moins 1A, en provenance de la deuxième borne du circuit de limitation de tension.

Il est également proposé un système d'interrupteur comportant :
- un interrupteur principal comportant :
   - une première borne,
   - une deuxième borne, et
   - une borne de commande,
   la première borne et la deuxième borne présentant entre elles une première tension,
   la borne de commande et la deuxième borne présentant entre elles une deuxième tension contrôlant la première tension,
- un dispositif de limitation de tension selon l'invention, dont la deuxième borne est connectée à la première borne de l'interrupteur principal,
- une connexion de rétroaction entre la première borne du circuit de limitation de tension et la borne de commande de l'interrupteur,
   dans lequel le circuit de limitation de tension est conçu pour, lorsque la tension est supérieure au deuxième seuil, être dans un mode actif dans lequel le circuit de limitation de tension réalise une rétroaction de la première tension sur la deuxième tension de manière à limiter la première tension.

Il est également proposé un convertisseur électrique comportant au moins deux bras de commutation ayant chacun deux interrupteurs principaux connectés l'un à l'autre en un point milieu, et dans lequel chacun d'au moins un des interrupteurs principaux, de préférence tous, fait partie d'un système d'interrupteur selon l'invention.

### DESCRIPTION DES FIGURES

La figure 1 est un schéma électrique d'un convertisseur électrique mettant en oeuvre l'invention.
La figure 2 est une série de chronogrammes illustrant l'évolution au cours du temps de différentes grandeurs électriques du convertisseur électrique de la figure 1.

### DESCRIPTION DÉTAILLÉE

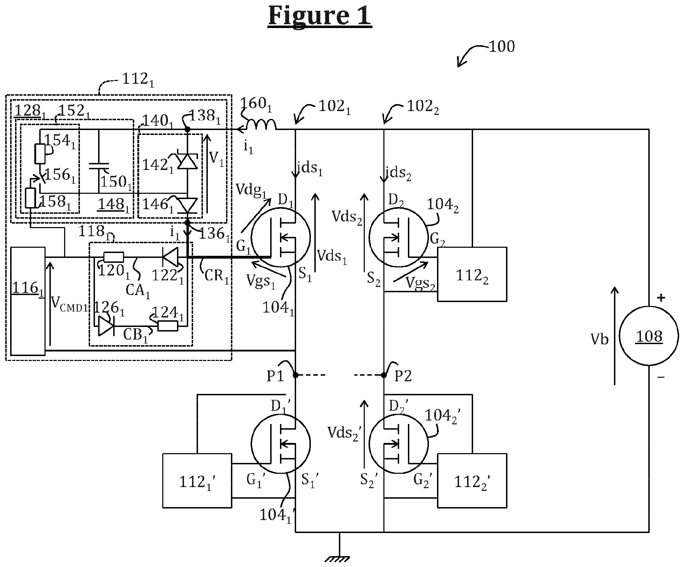

En référence à la figure 1, un convertisseur électrique 100 mettant en oeuvre l'invention va à présent être décrit.

Le convertisseur électrique 100 comporte plusieurs bras de commutation. Dans l'exemple décrit, le convertisseur électrique 100 comporte deux bras de commutation, désignés respectivement par les références 102₁ et 102₂. Dans la suite de la description, l'indice « 1 » sera utilisé pour les éléments se rapportant au premier bras de commutation 102₁, tandis que l'indice « 2 » sera utilisé pour les éléments se rapportant au deuxième bras de commutation 102₂.

Chaque bras de commutation 102₁, 102₂ comporte un interrupteur de côté haut 104₁, 104₂ et un interrupteur de côté bas 104₁', 104₂'. Dans la suite de la description, le signe prime « ' » sera utilisé pour désigner les éléments se rapportant au côté bas.

Chaque interrupteur 104₁, 104₁', 104₂, 104₂' présente une première borne D₁, D₁', D₂, D₂' une deuxième borne S₁, S₁', S₂, S₂' et une borne de commande G₁, G₁', G₂, G₂' et est conçu pour prendre sélectivement un état ouvert et un état fermé en fonction de la tension entre sa deuxième borne S₁, S₁', S₂, S₂' et sa borne de commande G₁, G₁', G₂, G₂'.

Dans l'exemple décrit, les interrupteurs 104₁, 104₁', 104₂, 104₂' sont des MOSFET (de l'anglais *« Metal Oxide Semiconductor Field Effect Transistor »* soit : transistor à effet de champ à grille isolée) présentant un drain, une source et une grille, formant respectivement la première borne, la deuxième borne et la borne de commande. Par soucis de clarté, les termes « drain », « source » et « grille » seront ainsi utilisés dans la suite de la description à la place des termes « première borne », « deuxième borne » et « borne de commande ».

Pour chaque interrupteur 104₁, 104₁', 104₂, 104₂', le drain D₁, D₁', D₂, D₂' et la source S₁, S₁', S₂, S₂' présentent entre eux une tension drain-source Vds₁, Vds₁', Vds₂, Vds₂'. La grille G₁, G₁', G₂, G₂' et la source S₁, S₁', S₂, S₂' présentent entre elles une tension grille-source Vgs₁, Vgs₁', Vgs₂, Vgs₂' contrôlant en particulier la tension drain-source Vds₁, Vds₁', Vds₂, Vds₂'.

Pour chaque bras de commutation 102₁, 102₂, la source de l'interrupteur de côté haut 104₁, 104₂ et le drain de l'interrupteur de côté bas 104₁', 104₂' sont connectés l'un à l'autre en un point milieu P1, P2 destiné à être connecté à une bobine (symbolisée par des traits pointillés) d'une machine électrique telle qu'un moteur électrique.

Les bras de commutation 102₁, 102₂ sont connectés à une source de tension continue 108, telle qu'une batterie ou un condensateur chargé, fournissant une tension Vb. Plus précisément, pour chaque bras de commutation 102₁, 102₂, le drain D₁, D₂ de l'interrupteur de côté haut 104₁, 104₂ est connecté à une borne positive de la source de tension continue 108, tandis que la source S₁', S₂' de l'interrupteur de côté bas 104₁', 104₂' est connecté à une borne négative (connectée généralement à une masse électrique) de la source de tension continue 108.

Dans l'exemple décrit, le courant de fuite vue par la source de tension continue 108 lorsque tous les interrupteurs de côté haut 104₁, 104₂ et de côté bas 104₁', 104₂' du convertisseur électrique 100 sont ouverts est limité à 200 µA, voire à 100 µA. En d'autres termes, dans l'exemple décrit ici, le courant de fuite traversant chacun des deux bras de commutation du convertisseur électrique 100 est limité à 100 µA, voire à 50 µA.

Le convertisseur électrique 100 comporte en outre, pour chaque interrupteur 104₁, 104₁', 104₂, 104₂', un circuit de commande 112₁, 112₁', 112₂, 112₂' respectif.

Sur la figure 1 et dans la description qui va suivre, seul le circuit de commande 112₁ de l'interrupteur de côté haut 104₁ est détaillé, sachant que les autres circuits de commande 112₁', 112₂, 112₂' sont identiques.

Le circuit de commande 112₁ comporte tout d'abord un pilote 116₁ conçu pour fournir une tension de commande Vc₁ prenant sélectivement une première valeur de fermeture de l'interrupteur 104₁ (par exemple une valeur haute, par exemple 10 V dans l'exemple décrit) et une deuxième valeur d'ouverture de l'interrupteur 104₁ (par exemple une valeur basse, par exemple 0 V dans l'exemple décrit).

Le circuit de commande 112₁ comporte en outre une interface 118₁ conçue pour définir des vitesses différentes de fermeture et d'ouverture de l'interrupteur de côté haut 104₁.

Plus précisément, l'interface 118₁ comporte une connexion de commande CA₁ connectant le pilote 116₁ à la grille G₁. La connexion de commande CA₁ est destinée à être parcourue, lors de l'ouverture de l'interrupteur de côté haut 104₁, par un courant de décharge de la grille G₁. Dans l'exemple décrit, la connexion de commande CA₁ comporte une résistance 120₁ définissant une vitesse d'ouverture de l'interrupteur de côté haut 104₁ et une diode 122₁ agencée pour empêcher du courant de s'écouler dans la connexion de commande CA₁ jusqu'à la grille G₁.

L'interface 118₁ comporte en outre une connexion de commande CB₁ connectant le pilote 116₁ à la grille G₁. La connexion de commande CB₁ est destinée à être parcourue, lors de la fermeture de l'interrupteur de côté haut 104₁, par un courant de charge de la grille G₁. Dans l'exemple décrit, la connexion de commande CB₁ comporte une résistance 124₁ définissant une vitesse de fermeture de l'interrupteur de côté haut 104₁ et une diode 126₁ agencée pour empêcher du courant de s'écouler dans la connexion de commande CB₁ jusqu'au pilote 116₁.

Ainsi, les diodes 122₁, 126₁ permettent de s'assurer que la résistance souhaitée 120₁, 124₁ est utilisée pour respectivement l'ouverture et la fermeture de l'interrupteur de côté haut 104₁.

En outre, les résistances 120₁ et 124₁ ont de préférence des valeurs différentes de manière à définir des vitesses différentes d'ouverture et de fermeture.

Le circuit de commande 112₁ comporte en outre un circuit de limitation de tension 128₁ (de l'anglais *« active camping »*) comportant une première borne 136₁ et une deuxième borne 138₁. Une tension d'entrée V₁ est destinée à être présentée sur la deuxième borne 138₁ par rapport à la première borne 136₁. Le circuit de limitation de tension 128₁ est conçu pour limiter la tension drain-source Vds₁ comme cela sera expliqué par la suite.

Le circuit de limitation de tension 128₁ comporte un premier circuit 140₁ comportant, dans l'exemple décrit, une diode Zener 142₁ et une diode 146₁ montés en série entre la première borne 136₁ et la deuxième borne 138₁. Plus précisément, la diode Zener 142₁ présente une cathode connectée à la deuxième borne 138₁ et la diode 146₁ présente une cathode connectée à la première borne 136₁ et une anode connectée à une anode de la diode Zener 142₁. La diode Zener 142₁ présente une tension de claquage Vz et la diode 146₁ présente une tension de déclenchement Vd.

Ainsi, lorsque la tension d'entrée V₁ est inférieure à la tension de déclenchement Vd, la diode 146₁ est bloquante de sorte qu'elle empêche sensiblement l'entrée de courant par la première borne 136₁ et en outre qu'elle fait présenter par le premier circuit 140₁, c'est-à-dire sur la branche comportant la diode Zener 142₁ et la diode 146₁, une résistance élevée entre les deux bornes 136₁, 138₁, par exemple d'au moins 100 kΩ, de préférence d'au moins 1 MΩ.

Lorsque la tension d'entrée V₁ est supérieure à la tension de déclenchement Vd et inférieure à un premier seuil VS1 (sensiblement égal dans l'exemple décrit à la somme de la tension de claquage Vz et de la tension de déclenchement Vd), la diode Zener 142₁ est bloquante de sorte qu'elle empêche sensiblement l'entrée de courant par la deuxième borne 138₁ et en outre qu'elle fait présenter par le premier circuit 140₁ une résistance élevée entre les deux bornes 136₁, 138₁, par exemple d'au moins 100 kΩ, de préférence d'au moins 1 MΩ.

Lorsque la tension d'entrée V₁ augmente autour du premier seuil VS1, la diode Zener 142₁ devient progressivement passante de sorte qu'un courant commence à s'écouler de la deuxième borne 138₁ jusqu'à la première borne 136₁ au travers du premier circuit 140₁ et de sorte que le premier circuit 140₁ présente une résistance entre les deux bornes 136₁, 138₁ qui diminue.

Lorsque la tension d'entrée V₁ est supérieure au premier seuil VS1, la diode Zener 142₁ est passante de sorte qu'un courant s'écoule de la deuxième borne 138₁ jusqu'à la première borne 136₁ au travers du premier circuit 140₁. Ainsi, le premier circuit 140₁ présente une résistance faible entre les deux bornes 136₁, 138₁, 100 fois plus faible que la résistance élevée présentée lorsque la tension V₁ est inférieure au premier seuil VS1. La résistance faible est par exemple d'au plus 100 Ω, de préférence d'au plus 10 Ω. Ainsi, le circuit de limitation de tension 128₁ est dans un mode actif dans lequel la tension entre les deux bornes 136₁, 138₁ est sensiblement constante à la valeur du premier seuil VS1.

Le circuit de limitation de tension 128₁ comporte en outre un deuxième circuit 148₁ comportant une capacité 150₁ présentant une première borne connectée à la deuxième borne 138₁ du circuit de limitation de tension 128₁ et une deuxième borne connectée à l'anode de la diode 146₁.

Lorsque la tension d'entrée V₁ est inférieure à un deuxième seuil VS2 (sensiblement égal dans l'exemple décrit à la tension de déclenchement Vd), la tension V₁ se retrouve essentiellement aux bornes de la diode 146₁ de sorte que la tension aux bornes de la capacité 150₁ reste sensiblement nulle et que la capacité 150₁ est parcourue par un courant sensiblement nul.

Lorsque la tension d'entrée V₁ augmente à partir du deuxième seuil VS2 jusqu'au premier seuil VS1, la tension aux bornes de la diode 146₁ reste sensiblement constante à ce deuxième seuil VS2 de sorte que la tension aux bornes de la capacité 150₁ est sensiblement égale à V₁-VS2 et qu'un courant traverse la capacité 150₁ en fonction de la variation de cette tension à ses bornes. Ce courant entre donc par la deuxième borne 138₁ du circuit de limitation de tension 128₁.

Lorsque la tension V₁ atteint puis devient supérieure au premier seuil VS1, la tension V1 reste sensiblement constante à la valeur du premier seuil VS1 de sorte que la tension aux bornes de la capacité 150₁ reste sensiblement constante et que le courant la traversant est sensiblement nul.

Le deuxième circuit 148₁ comporte en outre un troisième circuit 152₁ conçu pour recevoir une commande de décharge et, en réponse à la réception de la commande de décharge, décharger la capacité 150₁.

Le troisième circuit 152₁ comporte une résistance 154₁ et un interrupteur 156₁ commandé par la tension de commande V_{CMD1} fournie par le pilote 116₁. Lorsque la tension de commande V_{CMD1} prend sa valeur d'ouverture (0 V), l'interrupteur 156₁ est également commandé à l'ouverture et déconnecte la résistance 154₁ de la capacité 150₁ de manière à empêcher la décharge de cette dernière dans la résistance 154₁. Lorsque la tension de commande V_{CMD1} prend sa valeur de fermeture (10 V), l'interrupteur 156₁ est également commandé à la fermeture et connecte la résistance 154₁ à la capacité 150₁ de manière à permettre la décharge de cette dernière dans la résistance 154₁.

L'interrupteur 156₁ comporte par exemple un MOSFET présentant une grille connectée au pilote 116₁ au travers d'une résistance 158₁ destinée à régler la vitesse de fermeture et d'ouverture de l'interrupteur 156₁.

La première borne 136₁ du circuit de limitation de tension 128₁ est connectée à la grille G₁ par une connexion de rétroaction CR₁ (représentée en trait épais sur la figure 1).

La deuxième borne 138₁ du circuit de limitation de tension 128₁ est connectée au drain D₁. Cette connexion au drain D₁ n'est pas parfaite de sorte qu'elle comporte une inductance parasite 160₁.

En supposant la tension aux bornes de l'inductance parasite 160₁ nulle, la tension d'entrée V₁ est égale à la tension drain-grille Vdg₁. Ainsi, lorsque la tension drain-grille Vdg₁ est supérieure au premier seuil VS1, le circuit de limitation de tension 128₁ est dans son mode actif dans lequel il réalise une rétroaction de la tension drain-source Vds₁ sur la tension grille-source Vgs₁ de manière à limiter la tension drain-source Vds₁. Cette rétroaction est la suivante. Lorsque la tension drain-source Vds₁ augmente, la tension grille-source Vgs₁ augmente également car, la tension drain-grille Vdg₁ est maintenue relativement constante au premier seuil VS1 par le circuit de limitation de tension 128₁ Or, cette augmentation de la tension grille-source Vgs₁ tend à faire baisser la tension drain-source Vds₁. Ainsi, la tension drain-source Vds₂ est limitée.

En outre, lorsque tous les interrupteurs de côté haut 104₁, 104₂ et de côté bas 104₁', 104₂' du convertisseur électrique 100 sont ouverts, les interrupteurs 156₁, 156₂, 156₁' et 156₂' sont également ouverts. Ainsi aucun courant ne circule dans les résistances 154₁, 154₂, 154₁' et 154₂' ce qui limite le courant de fuite circulant dans chacun des deux bras de commutation du convertisseur électrique 100.

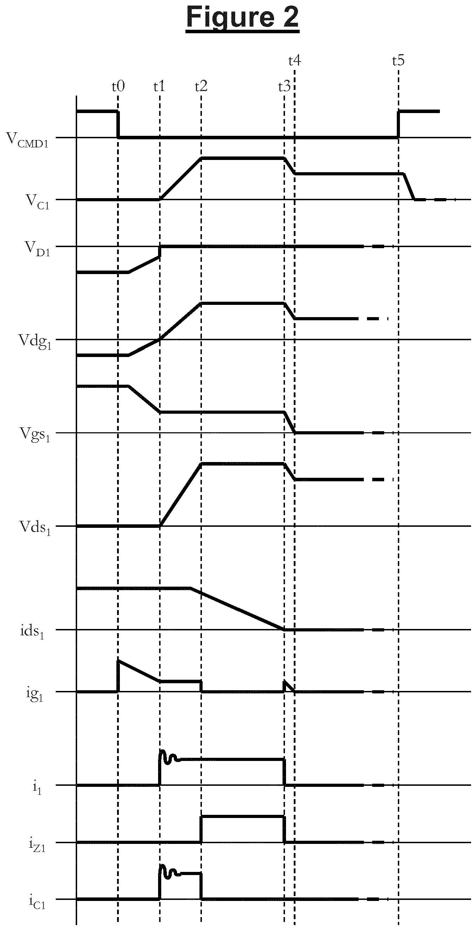

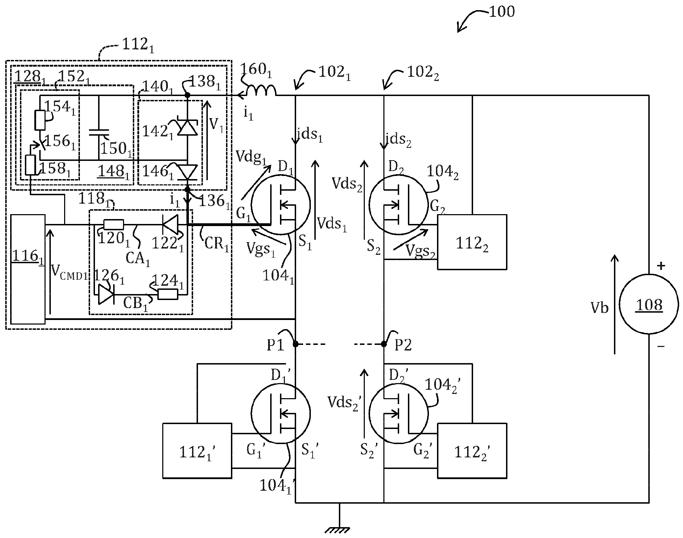

En référence à la figure 2, le fonctionnement du convertisseur électrique 100 lors de l'ouverture puis de la fermeture de l'interrupteur de côté haut 104₁ va à présent être décrit. Par la suite, les tensions de seuil des diodes seront négligées. Ainsi, dans cet exemple, le premier seuil VS1 est sensiblement égal à la tension de claquage Vz et le deuxième seuil VS2 est sensiblement égal à zéro.

Initialement, avant un instant t0, l'interrupteur de côté haut 104₁ est à l'état fermé : le courant de drain ids₁ est constant, la tension grille-source Vgs₁ est égale à la tension de commande V_{CMD1} à sa valeur de fermeture (10 V), la tension drain-source Vds₁ est nulle et la tension drain-grille Vdg₁ est égale à l'opposé de la tension grille-source Vgs₁, et donc négative. La tension aux bornes de la diode 146₁, notée V_{D1}, est ainsi égale à la tension drain-grille Vdg₁. Aucun courant i₁ ne rentre dans le circuit de limitation de tension 128₁ par sa deuxième borne 138₁. Ainsi, le courant traversant la diode Zener 142₁, noté i_{z1}, et le courant traversant la capacité 150₁, noté i_{c1}, sont tous les deux nuls.

À un instant t0, le pilote 116₁ commande l'ouverture de l'interrupteur de côté haut 104₁ en fournissant à l'interface 118₁ la tension de commande V_{CMD1} à sa valeur d'ouverture (0 V). La tension grille-source Vgs₁ commence à diminuer et la tension drain-grille Vdg₁ commence à augmenter.

La tension de commande V_{CMD1} à sa valeur d'ouverture (0 V) est également fournie à l'interrupteur 156₁ au travers de la résistance 158₁. Ainsi, l'interrupteur 156₁ passe à l'état ouvert, de sorte que la capacité 150₁ ne puisse pas se décharger dans la résistance 154₁.

À un instant t1, la tension grille-source Vgs₁ atteint un plateau, la tension drain-grille Vdg₁ (égale à la tension d'entrée V₁) atteint puis devient supérieure au deuxième seuil VS2 (qui est nul) et la tension drain-source Vds₁ commence à augmenter. La tension drain-grille Vdg₁ est donc appliquée à la capacité 150₁ et l'inductance parasite 160₁ qui forment un système oscillant. Dans l'exemple décrit, la tension drain-grille Vdg₁ augmente sensiblement linéairement. De ce fait, le courant i₁ commence à osciller puis se stabilise autour d'une valeur de régime permanent. Du courant i₁ entre ainsi dans le circuit de limitation de tension 128₁ par la deuxième borne 138₁ pour traverser la capacité 150₁ (ici = i₁) et la diode 146₁ et sortir par la première borne 136₁.

À un instant t2, la tension drain-source Vds₁ atteint le premier seuil VS1 de sorte que le circuit de limitation de tension 128₁ devient actif et maintient la tension drain-source Vds₁ sensiblement égale au premier seuil VS1. La diode Zener 142₁ est alors à l'état passant de sorte que le courant i_{z1} devient non nul.

Comme cela est visible sur la figure 2, au moment de l'établissement du courant i_{z1}, le courant i₁ est non nul grâce à la présence de la capacité 150₁. Ainsi, il n'y a pas de brusque augmentation du courant i₁ à cet instant qui risquerait d'entraîner une forte tension aux bornes de l'inductance parasite 160₁. Plus précisément, en l'absence de la capacité 150₁, le courant i₁ serait égal au courant i_{z1}.Ainsi, lors de l'activation du circuit de limitation de tension 128₁, le courant i₁ aurait tendance à augmenter brusquement de sorte qu'une surtension importante apparaitrait aux bornes de l'inductance parasite 160₁, qui serait répercutée sur la tension drain source Vds₁.

L'inductance parasite 160₁ et la diode Zener 142₁ forment un système oscillant amorti, de sorte qu'après l'instant t2, la tension drain-grille Vdg₁ oscille autour du premier seuil VS1. Grâce à la présence d'un courant i₁ non nul à l'instant t2, ces oscillations sont très petites de sorte qu'elles n'ont pas été représentées sur la figure 2.

Lorsque les oscillations sont devenues négligeables, la tension drain-grille Vdg₁ est sensiblement égale à la tension d'entrée V₁ et est maintenue égale sensiblement au premier seuil VS1. Le circuit de limitation de tension 128₁ réalise alors la rétroaction de la tension drain-source Vds₁ sur la tension grille-source Vgs₁ de manière à maintenir limitée la tension drain-source Vds₁. Ainsi, la tension grille-source Vgs₁ et la tension drain-source Vds₁ sont maintenues relativement constantes. Cela se traduit en particulier par un courant de décharge de la grille G1, noté ig₁, qui s'annule.

À un instant t3, le courant ids₁ devient nul. La grille G1 finit alors sa décharge et la tension Vds₁ diminue jusqu'à la tension de batterie Vb à un instant t4.

À un instant t5, le pilote 116₁ commande la fermeture de l'interrupteur de côté haut 104₁ en fournissant la tension V_{CMD1} à sa valeur de fermeture (10 V). La tension V_{CMD1} à sa valeur de fermeture (10 V) forme une commande de décharge reçue par le troisième circuit 152₁. En réponse à la réception de cette commande de décharge, l'interrupteur 156₁ se ferme et connecte la résistance 154₁ à la capacité 150₁ de sorte que cette dernière se décharge dans la résistance 154₁ (la tension V_{C1} retourne à zéro) pour être à nouveau opérationnelle à la prochaine ouverture de l'interrupteur de côté haut 104₁.

La présente invention n'est pas limitée au mode de réalisation décrit précédemment, mais est au contraire définie par les revendications qui suivent. Il sera en effet apparent à l'homme du métier que des modifications peuvent y être apportées.

Par exemple, la capacité 150₁ et le troisième circuit 152₁ pourraient être remplacés par une résistance.

Par ailleurs, les termes utilisés dans les revendications ne doivent pas être compris comme limités aux éléments du mode de réalisation décrit précédemment, mais doivent au contraire être compris comme couvrant tous les éléments équivalents que l'homme du métier peut déduire à partir de ses connaissances générales.

## Revendications

1. Circuit de limitation de tension (128₁) comportant :
- une première borne (136₁) et une deuxième borne (138₁), une tension d'entrée (V₁) étant destinée à être présentée sur la deuxième borne (138₁) par rapport à la première borne (136₁),
- un premier circuit (140₁) connecté entre la première borne (136₁) et la deuxième borne (138₁) et conçu pour :
- lorsque la tension d'entrée (V₁) est inférieure à un premier seuil, présenter une résistance élevée entre la première borne (136₁) et la deuxième borne (138₁),
- lorsque la tension d'entrée (V₁) est supérieure au premier seuil, présenter une résistance faible, au moins 100 fois plus faible que la résistance élevée, entre la première borne (136₁) et la deuxième borne (138₁),
**caractérisé en ce qu'**il comporte en outre :
- un deuxième circuit (148₁) connecté à la deuxième borne (138₁) et conçu pour, lorsque la tension d'entrée (V₁) augmente depuis un deuxième seuil jusqu'au premier seuil, recevoir du courant en provenance de la deuxième borne (138₁).

2. Circuit de limitation de tension (128₁) selon la revendication 1, dans lequel le deuxième circuit (148₁) comporte une capacité (150₁) présentant une première borne connectée à la deuxième borne (138₁) du circuit de limitation de tension (128₁).

3. Circuit de limitation de tension (128₁) selon la revendication 1 ou 2, dans lequel le premier circuit (140₁) comporte une diode (146₁) présentant une cathode connectée à la première borne (136₁) du circuit de limitation de tension (128₁).

4. Circuit de limitation de tension (128₁) selon les revendications 2 et 3, dans lequel la capacité (150₁) présente une deuxième borne connectée à une anode de la diode (146₁).

5. Circuit de limitation de tension (128₁) selon l'une quelconque des revendications 1 à 4, dans lequel le premier circuit (140₁) comporte en outre une diode Zener (142₁) présentant une cathode connectée à la deuxième borne (138₁) du circuit de limitation de tension (128₁).

6. Circuit de limitation de tension (128₁) selon la revendication 5 et l'une quelconque des revendications 3 et 4, dans lequel la diode Zener (142₁) comporte une anode connectée à une anode de la diode (146₁).

7. Circuit de limitation de tension (128₁) selon l'une quelconque des revendications 1 à 6, dans lequel le deuxième circuit (148₁) comporte en outre un troisième circuit (152₁) conçu pour recevoir une commande de décharge et, en réponse à la réception de la commande de décharge, décharger la capacité (150₁).

8. Circuit de limitation de tension (128₁) selon la revendication 7, dans lequel le troisième circuit (152₁) comporte une résistance (154₁) et un interrupteur (156₁) conçu pour, en réponse à la commande de décharge, connecter la capacité (150₁) à la résistance (154₁) pour permettre une décharge de la capacité (150₁) dans la résistance (154₁).

9. Circuit de limitation de tension (128₁) selon l'une quelconque des revendications 1 à 8, dans lequel le premier circuit (140₁) est conçu pour, lorsque la tension d'entrée (V₁) est inférieure au premier seuil, présenter une résistance d'au moins 100 kΩ, de préférence d'au moins 1 MΩ, entre les bornes (136₁, 138₁) du circuit de limitation de tension (128₁).

10. Circuit de limitation de tension (128₁) selon l'une quelconque des revendications 1 à 9, dans lequel le premier circuit (140₁) est conçu pour, lorsque la tension d'entrée (V₁) est supérieure au premier seuil, présenter une résistance d'au plus 100 Ω, de préférence d'au plus 10 Ω, entre les bornes (136₁, 138₁) du circuit de limitation de tension (128₁).

11. Circuit de limitation de tension (128₁) selon l'une quelconque des revendications 1 à 10, dans lequel le deuxième circuit (148₁) est conçu pour, lorsque la tension d'entrée (V₁) augmente à une vitesse comprise entre 50V par µs et 200V par µs depuis le deuxième seuil jusqu'au premier seuil, recevoir un courant d'au moins 10mA, de préférence d'au moins 100 mA, de préférence encore d'au moins 200 mA, en provenance de la deuxième borne (138₁) du circuit de limitation de tension (128₁).

12. Circuit de limitation de tension (128₁) selon l'une quelconque des revendications 1 à 10, dans lequel le deuxième circuit (148₁) est conçu pour, lorsque la tension d'entrée (V₁) augmente à une vitesse comprise entre 50V par µs et 2000V par µs depuis le deuxième seuil jusqu'au premier seuil, recevoir un courant d'au moins 10mA, de préférence d'au moins 100 mA, de préférence encore d'au moins 200 mA, de préférence encore d'au moins 1A, en provenance de la deuxième borne (138₁) du circuit de limitation de tension (128₁).

13. Système d'interrupteur comportant :
- un interrupteur principal (104₁) comportant :
- une première borne (D₁),
- une deuxième borne (S₁), et
- une borne de commande (G₁),
la première borne (D₁) et la deuxième borne (S₁) présentant entre elles une première tension (Vds₁),
la borne de commande (G₁) et la deuxième borne (S₁) présentant entre elles une deuxième tension (Vgs₁) contrôlant la première tension (Vds₁),
- un circuit de limitation de tension (128₁) selon l'une quelconque des revendications 1 à 11, dont la deuxième borne (138₁) est connectée à la première borne (D₁) de l'interrupteur principal (104₁),
- une connexion de rétroaction (CR₁) entre la première borne (136₁) du circuit de limitation de tension (128₁) et la borne de commande (G₁) de l'interrupteur principal (104₁),
dans lequel le circuit de limitation de tension (128₁) est conçu pour, lorsque la tension (V₁) est supérieure au deuxième seuil (VS2), être dans un mode actif dans lequel le circuit de limitation de tension (128₁) réalise une rétroaction de la première tension (Vds₁) sur la deuxième tension (Vgs₁) de manière à limiter la première tension (Vds₁).

14. Convertisseur électrique (100) comportant au moins deux bras de commutation (102₁, 102₂) ayant chacun deux interrupteurs principaux (104₁, 104₁' ; 104₂, 104₂') connectés l'un à l'autre en un point milieu, et dans lequel chacun d'au moins un des interrupteurs principaux (104₁, 104₁' ; 104₂, 104₂'), de préférence tous, fait partie d'un système d'interrupteur selon la revendication 13.
